# EUROPEAN PATENT APPLICATION

(11) **EP 2 479 740 A1**
(43) Date of publication of application: **25.07.2012**
(21) Application number: 10816669.5
(22) Date of filing: 07.09.2010
(51) Int. Cl.: G09F 9/33

(54) **HIGH-TRANSPARENT LED DISPLAY MODULE**

(30) Priority: 18.09.2009 CN 200910190484
(71) Applicant: GWS Technology (Shenzhen) Co., Ltd., Shenzhen, Kengzi Town (CN)
(72) Inventor: GWS Technology (Shenzhen) Co., Ltd., Shenzhen, Kengzi Town (CN)
(74) Representative: Jeannet, Olivier
(86) International application number: PCT/CN2010/076658
(87) International publication number: WO 2011/032465

(57) **Abstract**

A high-transparency LED display module, which comprises a transparent glass plate (1), and an LED luminous unit and a main driving unit (4) which are lined linearly; the transparent glass plate (1) is provided with lamp holes (101) which are lined based on pixel pitch, and the lamp holes (101) which are horizontally or vertically lined along the transparent glass plate (1) are provided with wiring ducts (102) which are vertical to the surface of the transparent glass plate (1); the LED luminous unit comprises a driving PCB board (201) and an LED luminous bodies (3) which are electrically connected with the PCB board (201); the driving PCB boards (201) are inlaid in the wiring ducts (102) of the transparent glass plate (1); the surface of the driving PCB board (201) is vertical to the surface of the transparent glass plate (1); the positions of the LED luminous bodies (3) correspond to the positions of the lamp holes (101); and the light of the LED luminous bodies (3) is axially vertical to the surface of the transparent glass plate (1). In the invention, the main PCB board is horizontally installed on an organic glass plate, thus greatly reducing the blockage of the PCB board to the light and improving the transparency of the module.

## Description

### Technical Field

The present invention relates to an LED luminous device, more particularly to a high-light-transparency LED display module.

### Background Art

LED display screen has been widely applied in the media field owing to its characteristics of flexible dimension and strong environmental adaptability. Some special places, like glass curtain wall, shop window, stage background, shopping market, hotel, airport, etc., are in need of an LED display module that has high transparency and good lighting and perspective effects, and also maintains particular pixel density simultaneously. Hence, plenty of bar-shaped LED display screens are available on the market, and such an LED screen is characterized in that LED luminous units are installed on many bar-shaped circuit boards and then fixed by an opaque housing, a plurality of lamp bars like these form a unit module, and a plurality of unit modules are then cascaded to form a display screen. The opaque housing requires a large space, so in order to guarantee certain light transparent effect, the pixel pitch in such a unit module needs to be more than 40mm in general, however, too large pixel pitch is not suitable for the situation in which watching distance is relatively small. Also, the bar-shaped structure of this opaque display module is quite prominent, so confining feeling will be brought to people regardless of indoor or outdoor installment thereof and it is inappropriate for high-grade places such as shop window, shop glass curtain wall and the like, in this case, there is a need from market for an LED display screen that has not only high pixel density, but high transparency.

### Summary of the Invention

The objective of the present invention is to overcome the defects in the prior art and provide a high-transparency LED display module with no complex frame structure, simple structure, convenient manufacturing and extremely high lighting and perspective effects.

In order to reach the above objective, the present invention adopts the technical proposal as follows:

A high-transparency LED display module comprises a transparent glass plate, and an LED luminous unit and a main driving unit which are lined linearly, the transparent glass plate is provided with lamp holes which are lined based on pixel pitch, and the lamp holes which are horizontally or vertically lined along the transparent glass plate are provided with wiring ducts which are vertical to the surface of the transparent glass plate; the LED luminous unit comprises driving PCB boards and LED luminous bodies which are electrically connected with the PCB board, the driving PCB boards are inlaid in the wiring ducts of the transparent glass plate, the surface of the driving PCB board is vertical to the surface of the transparent glass plate, the positions of the LED luminous bodies correspond to the positions of the lamp holes, and the light of the LED luminous bodies is axially vertical to the surface of the transparent glass plate.

The LED luminous unit further comprises an LED luminous body installing PCB board, the section of the LED luminous body installing PCB board is equivalent to that of the LED luminous body, and the installing PCB board is vertically fixed to the surface of the driving PCB board and electrically connected with the driving PCB board.

The lamp hole is a through hole or a blind hole.

The depth of the wiring duct is matched with the width of the driving PCB board.

The upper and lower surfaces of the driving PCB board are provided with symmetrical LED luminous bodies.

Both the front surface and the back surface of the LED luminous body installing PCB board are equipped with the LED luminous bodies.

The LED luminous body is a single-color or multicolor light-emitting diode.

The transparent glass plate is a high-transparency homogeneous substrate which is made of, but not limited to, PMMA (Acrylic) polymer material.

In the present invention, based on the characteristics of organic glass like eye-pleasing appearance, high transparency and great easiness for mechanical processing, the transparent glass plate is used as a substrate for LED module, meanwhile, the driving PCB boards that have a negative effect on light transparency are vertically installed on the surface of the transparent glass plate, thus greatly reducing the blockage of the driving PCB boards to light and improving the transparency and pixel density of the display module. Simultaneously, by means of organic connection between the LED luminous bodies and the driving PCB boards, the LED luminous bodies can be installed conveniently, and the function of double-surface display can also be realized, as a result, the utilization efficiency of the display module is raised. The high-transparency LED display module of the present invention can be directly installed on the inner side of a transparent glass curtain wall in an adhesive way so as to exhibit advertisement information, therefore, the space for installment is remarkably saved and the pixel density per unit area is increased, and the high-transparency LED display module can also be applied to signboard as well as shopping market, hotel, school, hospital, airport and other public places, so the present invention is quite promising in application.

### Brief Description of the Drawings

FIG.1 is a structural schematic diagram of the present invention;
FIG.2 is a rear view of the transparent glass plate;
FIG.3 is a sectional view of FIG.2 along A-A;
FIG.4 is a sectional view of FIG.2 along B-B;
FIG.5 is a structural schematic diagram of the driving PCB board and the installing PCB board of the LED luminous unit;
FIG.6 is a top view of the structure shown as FIG.5;
FIG.7 is a front view of FIG.5 after LED lamp is installed;
FIG.8 is a top view of the structure shown as FIG.7;
FIG.9 is a sectional view of FIG.1 along C-C;
FIG. 10 is a schematic diagram of the LED luminous body in accordance with the second embodiment of the present invention;
FIG.11 is a schematic diagram of the LED luminous body in accordance with the third embodiment of the present invention;
FIG.12 is a rear view of the present invention after the main driving unit and the framework are installed;
FIG.13 is a left view of FIG.12;
FIG.14 is a rear view of the third embodiment of the present invention.

### Detailed Description of the Embodiments

Detailed description is further made to the present invention with reference to the drawings and the embodiments.

Reference symbols in the accompanying drawings are as follows: transparent glass plate 1, lamp hole 101, wiring duct 102, driving PCB board 201, installing PCB board 202, LED luminous body 3 and main driving unit 4.

A high-transparency LED display module comprises a transparent glass plate 1, and an LED luminous unit and a main driving unit 4 which are lined linearly, the organic glass plate 1 is provided with lamp holes 101 which are lined based on pixel pitch, and the lamp holes 101 are through holes or blind holes. The lamp holes which are horizontally or vertically lined are provided with wiring ducts 102 which are vertical to the surface of the transparent glass plate, the depth of the wiring duct 102 is matched with the width of a driving PCB board 201. The LED luminous unit comprises the driving PCB board 201, LED luminous bodies 3 and an LED luminous body installing PCB board 202, the installing PCB board 202 is vertically fixed to the surface of the driving PCB board 201 and is electrically connected with the driving PCB board 201; the LED luminous bodies 3 are fixed on the surface of the installing PCB board 202 and are electrically connected with the installing PCB board 202; the driving PCB boards 201 are inlaid in the wiring ducts 102 of the transparent glass plate 1 in parallel, and the installing PCB boards 202 with the LED luminous bodies 3 fixed thereon correspond to the positions of the lamp holes 101.

### Embodiment 1

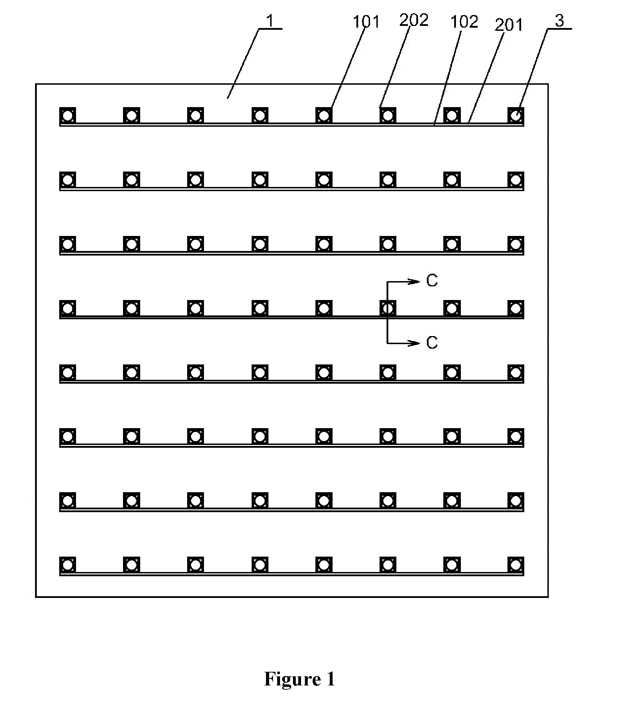

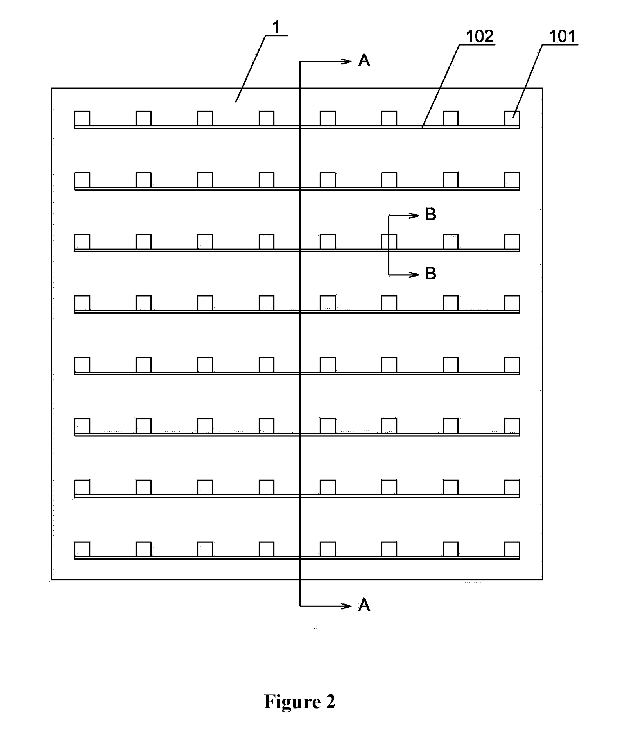

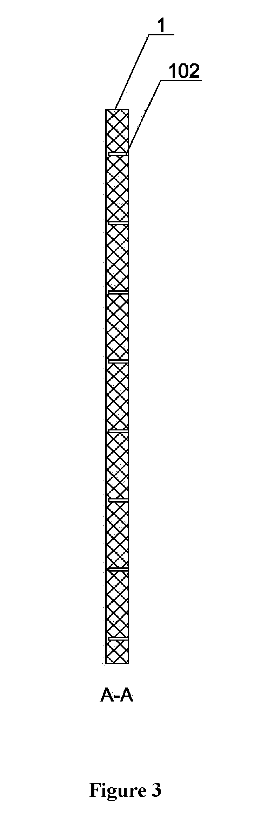

Shown as FIG.1 to FIG.3, the transparent glass plate 1 is an organic glass plate on which a plurality of lamp holes 101 are lined based on the desired pixel pitch (e.g. 16mm), and the lamp holes 101 are through holes. Wiring ducts 102 vertical to the surface of the organic glass plate are arranged along the direction of the horizontally lined lamp holes 101, and the wiring ducts 102 are arranged at the side edges of the lamp holes 101.

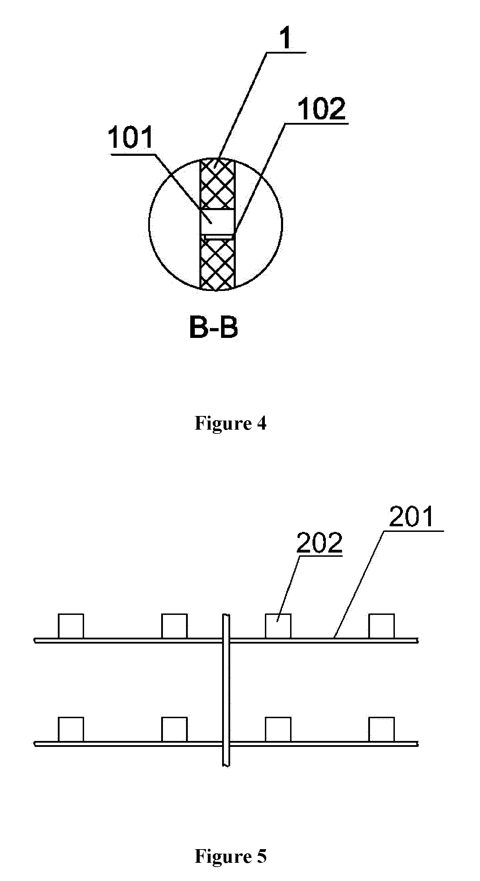

Shown as FIG.4 and FIG.5, an installing PCB board 202 is vertically fixed on an elongated driving PCB board 201, the pitch of the installing PCB boards 202 is identical to the pixel pitch, and the planar direction thereof is parallel to that of the organic glass plate 1.

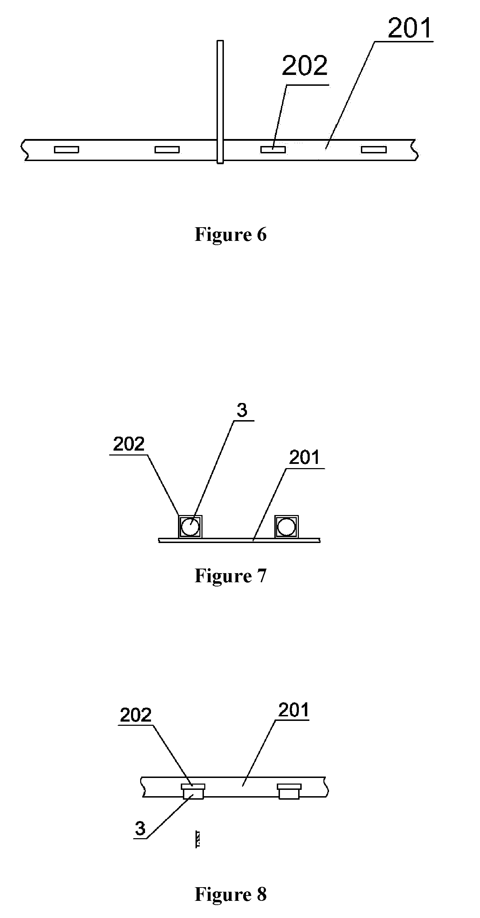

Shown as FIG.6 and FIG.7, a SMD chip LED luminous body is installed on the surface of the installing PCB board 202.

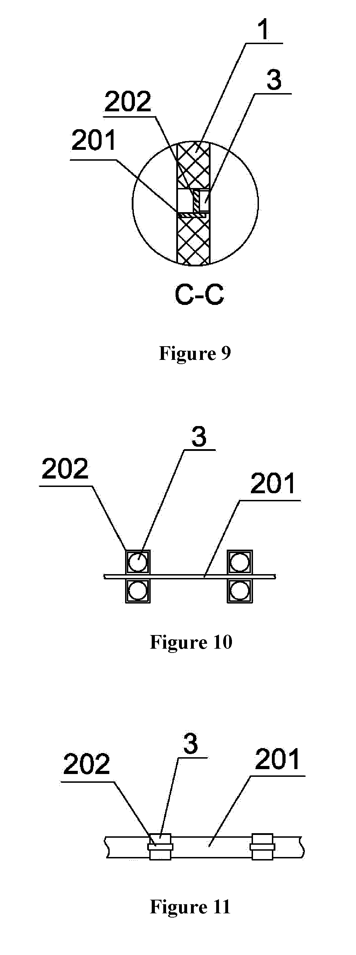

Shown as FIG.8 and FIG.9, the driving PCB board 201 is electrically connected with the installing PCB board and the operation of the LED luminous body 3 can be controlled, a control circuit of a main driving unit 4 is set in accordance with the control way required by the LED luminous body 3 in order to control the brightness and color change of the LED luminous body 3. The driving PCB boards 201 are inlaid in the wiring ducts 102 of the organic glass plate 1, thus the LED luminous bodies 3 are exactly located at the positions of the lamp holes 101. Small and thin driving elements are installed by the driving PCB boards, and driving elements with larger size are installed by the main driving units 4.

### Embodiment 2

Shown as FIG.10, the installing PCB boards 202 are symmetrically installed on the upper and lower surfaces of the driving PCB board 201, two LED luminous bodies 3 are installed on the installing PCB board 202 respectively, and the organic glass plate 1 is also correspondingly provided with two lamp holes 101 (not shown in the figure) at every pixel position, thus the luminous brightness of module can be enhanced and the space for driving circuit can be saved effectively.

### Embodiment 3

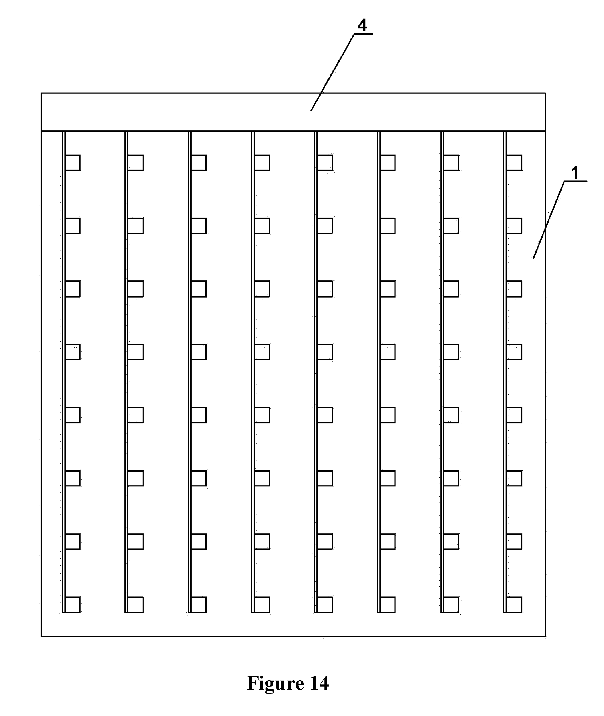

Shown as FIG.11, LED luminous bodies 3 are mounted on the front and back surfaces of the installing PCB board 202 respectively and are controlled by the same or different circuits printed on the driving PCB board 201 and the installing PCB board 202, as a result, luminous effect can be formed on two surfaces. The display module formed in such a manner can exhibit the same or different picture/text information. At this moment, the main driving unit 4 and the framework are installed at the side of the display module (shown as FIG.14) so that audiences at two sides of the display module can see complete picture/text information.

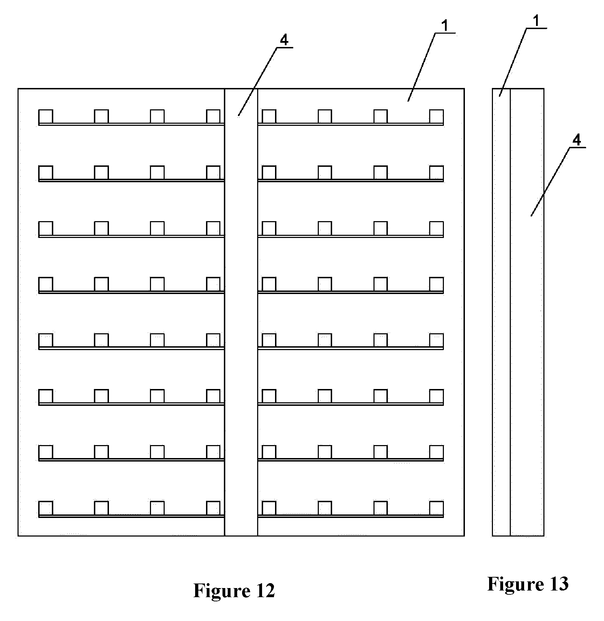

Shown as FIG. 12 and FIG.13, all the driving PCB boards 201 are controlled by driving circuits in the main driving units 4 so that the brightness and color change of all the LED luminous bodies 3 on the module can be controlled independently to form an LED unit module exhibiting picture/text information, and a plurality of LED unit modules like this are mutually cascaded to form an LED display screen of particular size. The modules can be directly adhered to the back surface of a glass curtain wall to exhibit picture/text information outside, thus quite high perspective effect can be generated when audiences see the display screen from inside, and the picture/text information exhibited can be seen when audiences see the display screen from outside. The present invention can realize quite high pixel density on limited area of the glass curtain wall, for example, in the case of 16mm pixel pitch, the pixel density can reach 3906 points/m², which is prominently increased in comparison with 625 points/m² of a bar-shaped screen with common 40mm pixel pitch.

Further, the transparent glass plate 1 can also be manufactured in an arc shape, and correspondingly, the driving PCB board 201 is manufactured in an arch shape as well in order to meet the special demand on the shape of LED display module; one glass plate can be additionally arranged in front of the transparent glass plate 1 to obtain a waterproof front part; and the transparent glass plate 1 can be manufactured in a bar shape along the direction of the driving PCB boards 201 to create the ventilating effect.

## Claims

1. A high-transparency LED display module, **characterized in that** the high-transparency LED display module comprises a transparent glass plate (1), and an LED luminous unit and a main driving unit (4) which are lined linearly; the transparent glass plate (1) is provided with lamp holes (101) which are lined based on pixel pitch, and the lamp holes (101) which are horizontally or vertically lined along the transparent glass plate (1) are provided with wiring ducts (102) which are vertical to the surface of the transparent glass plate (1); the LED luminous unit comprises a driving PCB board (201) and an LED luminous bodies (3) which are electrically connected with the PCB board (201); the driving PCB boards (201) are inlaid in the wiring ducts (102) of the transparent glass plate (1); the surface of the driving PCB board (201) is vertical to the surface of the transparent glass plate (1); the positions of the LED luminous bodies (3) correspond to the positions of the lamp holes (101); and the light of the LED luminous bodies (3) is axially vertical to the surface of the transparent glass plate (1).

2. The high-transparency LED display module according to claim 1, **characterized in that** the LED luminous unit further comprises an LED luminous body installing PCB board (202), the section of the LED luminous body installing PCB board (202) is equivalent to that of the LED luminous body (3), and the installing PCB board (202) is vertically fixed to the surface of the driving PCB board (201) and electrically connected with the driving PCB board.

3. The high-transparency LED display module according to claim 1, **characterized in that** the lamp hole (101) is a through hole or a blind hole.

4. The high-transparency LED display module according to claim 1, **characterized in that** the depth of the wiring duct (102) is matched with the width of the driving PCB board (201).

5. The high-transparency LED display module according to claim 1, **characterized in that** the upper and lower surfaces of the driving PCB board (201) are provided with symmetrical LED luminous bodies (3).

6. The high-transparency LED display module according to claim 1, **characterized in that** both the front surface and the back surface of the LED luminous body installing PCB board (202) are equipped with the LED luminous bodies (3).

7. The high-transparency LED display module according to any of claims 1, 2, 5 or 6, **characterized in that** the LED luminous body is a single-color or multicolor light-emitting diode.

8. The high-transparency LED display module according to claim 1, **characterized in that** the transparent glass plate (1) is a high-transparency homogeneous substrate which is made of, but not limited to, PMMA (Acrylic) polymer material.
